Europäisches Patentamt

European Patent Office

Office européen des brevets

(19)

(11) Publication number: **0 167 538**
**B1**

(12) **EUROPEAN PATENT SPECIFICATION**

(45) Date of publication of patent specification: **18.01.89**

(21) Application number: **84903829.4**

(22) Date of filing: **01.10.84**

(86) International application number:
**PCT/US84/01568**

(87) International publication number:
**WO 85/02941 04.07.85 Gazette 85/15**

(51) Int. Cl.⁴: **H 01 L 23/50**

(54) **FLAT PACKAGE FOR INTEGRATED CIRCUIT MEMORY CHIPS.**

(30) Priority: **28.12.83 US 566364**

(43) Date of publication of application:
**15.01.86 Bulletin 86/03**

(45) Publication of the grant of the patent:
**18.01.89 Bulletin 89/03**

(84) Designated Contracting States:
**DE**

(56) References cited:
**WO-A-81/02367**
**US-A-4 296 456**
**US-A-4 340 902**

**Patents Abstracts of Japan, vol. 5, no. 82
(E-59)(754), issued 29 May 1981**

(73) Proprietor: **Hughes Aircraft Company
7200 Hughes Terrace Bldg. C1, MS A-126
P.O.Box 45066
Los Angeles California 90045-0066 (US)**

(72) Inventor: **GATES, Louis, E., Jr.
31817 Larkspur Court
Westlake Village, CA 91361 (US)**

(74) Representative: **Kuhnen, Wacker & Partner
Schneggstrasse 3-5 Postfach 1553
D-8050 Freising (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention is directed to a flat package particularly arranged for the mounting of integrated circuit memory chips on a standard avionic printed circuit board without occupying excess space. The flat package is particularly configured for positioning within a standard flat pack cell on an avionics-style printed circuit board.

Integrated circuit chips are conventionally mounted in several kinds of chip carriers which provide pads to which connections can be made. These chip carriers, in turn, are in sealed packages which physically protect the integrated circuit chips and their wire bond connections. The dual in-line package is often used for this purpose, particularly in commercial installations. One of the standard sizes of a dual in-line package has 16 pins, and this is suitable for memory integrated circuit chips. Such a use is shown in Green, et al. U.S. patent 3,969,706 and in Faggin, et al. U.S. patent 3,821,715. From WO 81/02367 a dual-in-line package is shown in accordance with the prior art portion of claim 1. Dual in-line packages have pins which extend therefrom and can be inserted through openings in a printed circuit board for direct connection to printed circuits thereon. However, this is a problem in certain avionics style electronics assemblies which require surface mounted of their components. Holes through the avionics style printed circuit board for receipt of the dual in-line pins would be unacceptable because the through-hole pins would contact a metal heat exchanger beneath the printed circuit boards commonly used in such assemblies.

Flat packs for integrated circuit chips are known and used in avionics systems. These flat packs have defined standard cell sizes on avionics printed circuit boards.

The difference between integrated circuit memory chips and other integrated circuit logic chips is that the logic chips and their carriers have wire bonding pads most of the way around the periphery. This means that pads on the flat pack for a logic chip are along the long edges of the flat pack. This has led to development of the avionics style printed circuit board with cells defined for contacts along the long edges thereof and for a particular cell area defined on the printed circuit board for a flat pack having a particular number of connection points.

The wire bonding pads on integrated circuit memory chips are on the ends rather than along the sides of the chips. When such chips are mounted in a leadless chip carrier, the chip carrier must be much larger with a sufficient number of pads at the interior ends of the package in order to match the required number of pads at the ends of the integrated circuit memory chip. Typically, a leadless chip carrier with 18, 20 or even more pads is used to package a memory chip having only 16 pads. The extra pads along the interior sides of the leadless chip carrier are not used. Nevertheless, the larger leadless chip carrier now housing the integrated circuit memory chip occupies a much larger space on a printed circuit board. In one case, the cell size necessary on a printed circuit board to make proper connections for a 20 pin leadless chip carrier housing a 16 pad integrated circuit memory chip actually occupied the same area on the printed circuit board as that required for a 24 lead flat pack. Therefore, there is a need for a flat package useful for integrated circuit memory chips which brings out 16 connection points along the long edges of the flat package, with the flat package being sized to fit within a cell area on a printed circuit board suitable for a conventional 16 pad flat pack used for packaging an integrated circuit logic chip.

In order to aid in the understanding of this invention, it can be stated in essentially summary form that it is directed to a flat package for integrated circuit memory chips. According to a preferred embodiment the flat package is sized and configured as a 16 lead flat package with the lead extending from the longer edges. Internally of the package, the longitudinally organized connections of the integrated circuit memory chip are brought around to the edge-mounted leads.

It is, thus, a purpose and advantage of this invention to provide a flat package for integrated memory chips wherein a memory chip can be mounted within a cell of a size suitable to accept a 16 lead standard flat pack, thus to conserve space on the printed circuit board.

It is another purpose and advantage of this invention to provide a flat package having internal connections for translating the longitudinal lead connections of an integrated circuit chip to the lateral lead connections on a standard flat pack and to accomplish this in a space which conserves printed circuit board space and still provides proper protection for the integrated circuit memory chip, and its connections to the flat package so that the integrated circuit memory chip can be positioned in the smallest practical space and still be connected and protected.

Other purposes and advantages of this invention will become apparent from a study of the following portion of this specification, the claims and the attached drawings.

FIGURE 1 is an isometric view of the flat package for integrated circuit memory chips in accordance with this invention, with parts broken away and parts taken in section.

FIGURE 2 is an enlarged plan view thereof, with parts broken away and parts taken in section, as seen generally along the line 2—2 of FIGURE 3.

FIGURE 3 is a longitudinal section through the midpoint of the flat package as seen generally along the line 3—3 of FIGURE 2.

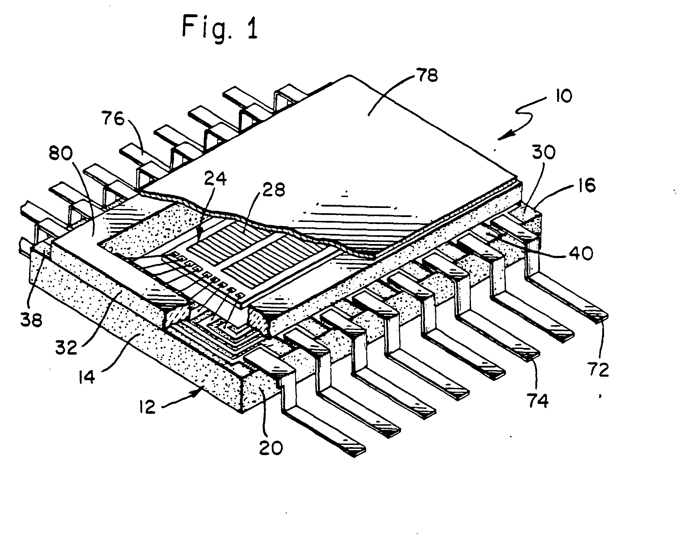

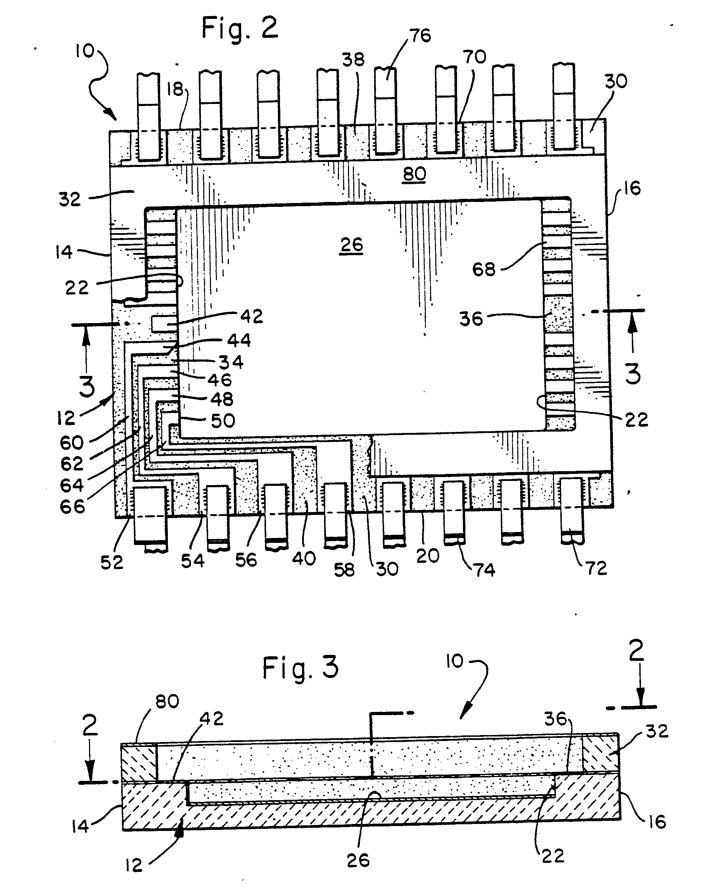

The flat package for integrated circuit memory chips in accordance with this invention is generally indicated at 10 in FIGURES 1, 2 and 3. Base 12 is of rectangular configuration having ends 14 and 16 as well as sides 18 and 20. The base 12 is of rectangular configuration and the ends and sides are at right angles to each other. Cavity 22 is formed in base 12. The bottom of cavity 22 is a metallized floor 26 on which integrated circuit memory chip 24, see FIGURE 1, is secured. The chip is secured by adhesive or soldering alloy attachment so the cavity 22 is just sufficiently larger than the chip to permit sliding movement of the chip within the cavity to work the adhesive into full engagement. Integrated circuit memory chip 24 contains memory circuit 28 thereon. The memory chip is organized in a longitudinal manner so that all of the electrical contacts are on the left and right ends of the chip when it is placed in the flat package 10 as it is shown in FIGURES 2 and 3. This means that the connections between the flat package and the chip are on the left and right interior ends of the flat package as seen in these figures.

Top surface 30 of base 12 has metallized surfaces thereon. These metallized surfaces are applied by conventional techniques, such as screen printing. Seal ring 32 is mounted on top surface 30 and seals with respect thereto. Seal ring 32 is also of ceramic material. As is seen in FIGURE 2, the seal ring 32 is sized so that its left and right ends are in line with the ends 14 and 16 of base 12. However, the open-centered rectangular structure of seal ring 32 is laterally larger on the inside that cavity 22 to leave exposed left and right ledges 34 and 36. These ledges are the exposed portion of the top surface 30 within the open-centered rectangular seal ring 32. Similarly, seal ring 32 has its rectangular interior opening in alignment with the sides of cavity 22, as is seen in FIGURE 2. However, these sides of the rectangular seal ring are not sufficiently wide to reach the sides 18 and 20 of base 12. Therefore, exterior upper and lower ledges 38 and 40 are formed exteriorly of the rectangular seal ring by leaving exposed that portion of the top surface 30.

Before the seal ring 32 is put in place, pads are provided on the interior ledges 34 and 36 and pads are provided on the exterior ledges 38 and 40. In addition, conductive metal traces connect the corresponding pads. The pads and traces are applied to the top surface 30 by means of screen printing and the component parts 12 and 32 are joined by sintering or thermal processing, with the conductive traces being buried within the now monolithic ceramic structure. Pad 42 is connected down to metallized floor 26 to permit grounding of the back surface or base of integrated circuit memory chip 24. Internal pads 44, 46, 48 and 50 are respectively connected to external pads 52, 54, 56 and 58. The connections are by means of conducting metal traces, respectively indicated at 60, 62, 64 and 66. What is critical about these traces is that they must be sufficiently small as to make the required connection within the required limited space. It is seen that the other internal pads are connected individually to the other external pads in the same manner. For example, internal pad 68 is connected to external pad 70, and so forth, on both ends of cavity 22. In this way, 16 leads off of an integrated circuit memory chip 24 can be connected to the interior pads at the end of cavity 22.

In a specific example, in a cell boundary space 11,4 mm (0.450 inch) in the left-to-right direction in FIGURE 2 and 16 mm (0.630 inch) in the up-and-down direction in FIGURE 2, base 12 has a width of 10,7 mm (0.420 inch) and a height of 8,1 mm (0.320 inch). With cavity 22 dimensioned to be 7,9 mm (0.310 inch) long in the left-to-right direction of FIGURE 2 and 4,8 mm (0.190 inch) wide in the up-and-down direction in FIGURE 2, the conductive metal traces are typically 0,13 mm (0.005 inch) wide and have a 0,13 mm (0.005 inch) spacing. Thus, the left and right ends of the base are crowded on top surface 30 with pads, traces and spaces to provide the required connections.

The leads on the flat package 10 start as a single chemically etched or stamped metal frame. In the frame configuration, the leads are attached to the exterior pads and secured thereto, such as by brazing. After the individual leads of the lead frame are secured to their pads, the outer portions of the lead frame are formed and trimmed off to leave behind the individual leads. Leads 72, 74 and 76 are illustrated in FIGURES 1 and 2, as illustrative of the 16 leads illustrated.

Integrated circuit memory chip 24 is placed within cavity 22 and is cemented or bonded to the floor 26 thereof. Wire bond connections interconnect the pads on the end of the integrated circuit memory chip and the interior pads on the interior and ledges adjacent the ends of cavity 22. The exterior leads are already in place. Thereupon, cover 78 is secured over seal ring 32, which has its top surface 80 metallized to permit attachment of the cover by soldering, welding or brazing. The flat package 10 is, thus, complete and ready to be placed upon an avionics style printed circuit board within a cell boundary suitable for the other 16-lead integrated circuit flat packaged devices. When it is positioned in its cell on the printed circuit board, its leads are connected to circuits in the board. Therefore, the flat package 10 for integrated circuit memory chips conserves space and can be mounted anywhere on the board where a 16-lead flat pack can be mounted.

**Claims**

1. A flat package for integrated circuit memory chips comprising:

a ceramic base (12), said base having a top surface (30), a cavity (22) in said base below said top surface, said base (12) being rectangular in shape and having a length greater than its width and said cavity (22) being rectangular in shape with its length greater than its width and with its length parallel to the length of said base (12), said cavity (22) having a bottom (22) on which can be attached an integrated circuit memory chip;

a plurality of metallized pads (44, 46, 48, 50, 52, 54, 56, 58) on said top surface (30) of said base (12) said plurality of metallized pads including internal pads (44, 46, 48, 50) at both ends of said base (12) adjacent said cavity (22) and external pads (52, 54, 56, 58) along both sides of said base (12) conductive metal traces (60, 62, 64, 66) interconnecting said internal pads (44, 46, 48, 50) at the ends of said cavity (22) with said external pads (52, 54, 56, 58) along the edges of said base (12), said pads and said traces being electrically separated from adjacent pads and traces; characterized by further comprising

a rectangular seal ring (32) having a rectangular opening therein, said seal ring (32) being secured to a portion of said top surface (30) of said base (12) such that its outer ends are aligned with outer ends (14, 16) of said base (12) and that the longer edges of its rectangular opening being aligned with the longer edges of said cavity (22) to leave exposed said internal pads (44, 46, 48, 50) on internal ledges (34, 36) at the ends of said cavity (22) accessible to said cavity and to leave exposed for exterior connection said external pads (52, 54, 56, 58) on external ledges (38, 40) along the longer edges (18, 20) of said base (12).

2. The flat package according to claim 1 characterized in that said seal ring (32) is ceramic and is ceramically bonded to the top surface (30) of said base (12).

3. The flat package according to claim 1 or 2 characterized in that said cavity (22) has a bottom (26) which is metallized and that there is a pad (52) provided on said base (12) connected to said metallized bottom (26).

4. The flat package according to claims 2 or 3 characterized in that said seal ring (32) is metallized on its top surface away from said base (12) and that a cover (78) is attached to said seal ring (32) for enclosing said cavity (22).

5. The flat package according to claims 1, 3 or 4 characterized by comprising leads (72, 74, 76) attached to said external pads (52, 54, 56, 58) on said external ledges (38, 40) for electrically connecting said flat package to a printed circuit board.

6. The flat package according to claim 1, characterized in that there are 16 external pads and that there are 16 leads (72, 74, 76) respectively connected to said 16 external pads (52, 54, 56, 58).

7. The flat package according to claim 6 characterized in that said package is sized to fit within a cell on a printed circuit board sized to except an integrated circuit chip in a standard flat pack, e.g. a 16-lead flat pack.

**Patentansprüche**

1. Flachgehäuse für integrierte Speicherschaltkreischips mit:

einer keramischen Basis (12), wobei die Basis eine obere Oberfläche (30), einen Hohlraum (22) in der Basis unterhalb der oberen Oberfläche aufweist, wobei die Basis (12) rechteckig und ihre Länge größer als ihre Breite ist, und der Hohlraum (22) rechteckig ist mit seiner Länge größer als seine Breite, und mit seiner Länge parallel zur Länge der Basis (12), wobei der Hohlraum (22) einen Boden (22) aufweist, auf dem ein integrierter Speicerschaltkreischip befestigt werden kann;

einer Mehrzahl von metallisierten Ànschlußflächen (44, 46, 48, 50, 52, 54, 56, 58) auf der oberen Oberfläche (30) der Basis (12), wobei die Mehrzahl der metallisierten Anschlußflächen innere Anschlußflächen (44, 46, 48, 50) an beiden Enden der Basis (12) in der Nähe des Hohlraums (22) und äußere Anschlußflächen (52, 54, 56, 58) entlang beider Seiten der Basis (12) aufweist, leitenden Metallbahnen (60, 62, 64, 66), die die inneren Anschlußflächen (44, 46, 48, 50) an den Enden des Hohlraums (22) mit den äußeren Anschlußflächen (52, 54, 56, 58) entlang den Rändern der Basis (12) miteinander verbinden, wobei die Anschlußflächen und Bahnen elektrisch von benachbarten Anschlußflächen und

Bahnen getrennt sind; gekennzeichnet durch einen rechteckigen Dichtring (32), der eine rechteckige Öffnung aufweist, und mit einem Teil der oberen Oberfläche (30) der Basis (12) derart verbunden ist, daß seine äußeren Enden mit äußeren Enden (14, 16) der Basis (12) fluchten und daß die längeren Ränder seiner rechteckigen Öffnung mit den längeren Rändern des Hohlraums (22) fluchten, um die internen Anschlußflächen (44, 46, 48, 50) auf inneren Leisten (34, 36) an den Enden des Hohlraums (22) frei zu dem Hohlraum zugängig zu lassen und um die äußeren Anschlußflächen (52, 54, 56, 58) auf äußeren Leisten (38, 40) entlang den längeren Rändern (18, 20) der Basis (12) für Verbindungen von außen zugängig zu lassen.

2. Flachgehäuse nach Anspruch 1, dadurch gekennzeichnet, daß der Dichtring (22) aus Keramik ist und keramisch mit der oberen Oberfläche (30) der Basis (12) verbunden ist.

3. Flachgehäuse nach Anspruch 1 oder 2, dadurch gekennzeichnet, daß der Hohlraum (22) einen Boden (26) aufweist, der metallisiert bzw. metallbeschichtet ist und daß eine Anschlußfläche (52) auf der Basis (12) vorgesehen ist, die mit dem metallisierten Boden (26) verbunden ist.

4. Flachgehäuse nach Anspruch 2 oder 3, dadurch gekennzeichnet, daß der Dichtring (32) auf seiner oberen Oberfläche weg von der Basis (12) metallisiert ist und daß ein Überzug (78) an dem Dichtring (32) zur Umschließung des Hohlraums (22) angebracht ist.

5. Flachgehäuse nach Anspruch 1, 3 oder 4, gekennzeichnet durch Leitungen (72, 74, 76) die auf den äußeren Anschlußflächen (52, 54, 56, 58) auf den äußeren Leisten (38, 40) befestigt sind, um das Flachgehäuse elektrisch mit einer gedruckten Leiterplatte zu verbinden.

6. Flachgehäuse nach Anspruch 1, dadurch gekennzeichnet, daß 16 äußere Anschlußflächen und 16 Leitungen (72, 74, 76) entsprechend verbunden mit den 16 äußeren Anschlußflächen (52, 54, 56, 58), vorgesehen sind.

7. Flachgehäuse nach Anspruch 6, dadurch gekennzeichnet, daß das Gehäuse solche Abmessungen aufweist, um in eine Zelle auf einer gedruckten Leiterplatte zu passen, die geeignet bemessen ist, um einen Chip mit integriertem Schaltkreis in einem Standardflachgehäuse, beispielsweise mit 16 Anschlüssen, aufzunehmen.

**Revendications**

1. Boîtier plat pour pucés de mémoires à circuits intégrés comprenant:

une base de céramique (12), cette base ayant une surface supérieure (30), une cavité (22) dans la base en-dessous de la surface supérieure, la base (12) ayant une forme rectangulaire et une longueur plus grande que la largeur et la cavité (22) ayant une forme rectangulaire et une longueur plus grande que la largeur et sa longueur parallèle à la longueur de la base (12), la cavité (22) ayant un fond (22) sur lequel il est possible de fixer des puces de mémoires à circuits intégrés;

une pluralité de pastilles métallisées (44, 46, 48, 50, 52, 54, 56, 58) sur la surface supérieure (30) de la base (12), cette pluralité de pastilles métallisées incluant des pastilles internes (44, 46, 48, 50) aux deux extrémités de la base (12) à proximité de la cavité (22) et des pastilles externes (52, 54, 56, 58) le long des deux côtés de la base (12), des voies en métal conductives (60, 62, 64, 66) interconnectant les pastilles internes (44, 46, 48, 50) aux extrémités de la cavité (22) avec les pastilles externes (52, 54, 56, 58) le long des bords de la base (12), les pastilles et voies étant séparées électriquement des pastilles et voies voisines; caractérisé en ce qu'il comprend en outre

une rondelle d'étanchéité rectangulaire (32) ayant une ouverture rectangulaire, la rondelle d'étanchéité (32) étant liée à une partie de la surface supérieure (30) de la base (12) de façon à ce que ses extrémités extérieures soient alignées avec les extrémités extérieures (14, 16) de la base (12) et que les bords les plus longs de son ouverture rectangulaire soient alignés avec les bords les plus longs de la cavité (22) pour laisser exposées les pastilles internes (44, 46, 48, 50) sur les bordures internes (34, 36) aux extrémités de la cavité (22) accessibles à la cavité et pour laisser exposées pour connexion externe les pastilles externes (52, 54, 56, 58) sur les bordures externes (38, 40) le long des bords les plus longs (18, 20) de la base (12).

2. Boîtier plat selon la revendication 1, caractérisé en ce que la rondelle d'étanchéité (32) est en céramique et qu'elle est reliée céramiquement à la surface supérieure (30) de la base (12).

3. Boîtier plat selon la revendication 1 ou 2, caractérisé en ce que la cavité (22) a un fond (26) métallisé et qu'une pastille (52) se trouve sur la base (12) connectée au fond métallisé (26).

4. Boîtier plat selon la revendication 2 ou 3, caractérisé en ce que la rondelle d'étanchéité (32) est métallisée sur sa surface supérieure loin de la base (12) et qu'une couverture (78) est fixée sur la rondelle d'étanchéité (32) pour inclure la cavité (22).

5. Boîtier plat selon la revendication 1, 3 ou 4, caractérisé en ce qu'il comprend des conduites (72, 74, 76) fixées sur les pastilles externes (52, 54, 56, 58) sur les bordures externes (38, 40) pour connecter électriquement le boîtier plat à une plaquette à circuits imprimés.

6. Boîtier plat selon la revendication 1, caractérisé en ce qu'il y a 16 pastilles externes et 16 conduites (72, 74, 76) connectées respectivement aux 16 pastilles externes (52, 54, 56, 58).

7. Boîtier plat selon la revendication 6, caractérisé en ce que le boîtier est dimensionné de façon à rentrer dans une cellule sur une plaquette à circuits imprimés dimensionnée de façon à recevoir des puces de mémoires à circuits imprimés dans un boîtier plat standard, par exemple avec 16 pastilles.

# Fig. 1

Fig. 2

Fig. 3